# EUROPEAN PATENT SPECIFICATION

(11) **EP 0 355 965 B1**
(45) Date of publication and mention of the grant of the patent: **15.02.1995**
(21) Application number: 89306821.3
(22) Date of filing: 05.07.1989
(51) Int. Cl.: H05K 3/40, H05K 1/18, H01L 23/538, H01L 21/48

(54) **A method of achieving selective inhibition and control of adhesion in thick-film conductors**
Verfahren zum Erreichen einer selektiven Adhäsionshemmung und -steuerung in Dickschicht-Leitern
Procédé pour obtenir une commande et un empêchement sélectif d'adhésion en conducteurs à film épais

(30) Priority: 16.08.1988 US 232743; 17.01.1989 US 297201; 17.01.1989 US 297212
(43) Date of publication of application: 28.02.1990
(73) Proprietor: DELCO ELECTRONICS CORPORATION (a Delaware corp.), Kokomo, Indiana 46902 (US)
(72) Inventor: Hearn, John Allen, Kokomo Indiana 46901 (US); Schwarz, Dwight Lance, Kokomo Indiana 46902 (US); Sarma, Dwadasi Hare Rama, West Lafayette Indiana 49706 (US); Palanisamy, Ponnusamy, Kokomo Indiana 46902 (US)
(74) Representative: Denton, Michael John

(56) References cited:
- EP-A- 0 044 247
- EP-A- 0 075 890
- EP-A- 0 245 697
- EP-A- 0 263 277
- FR-A- 2 479 639

## Description

This invention relates to compositions of matter that are useful in forming conductive patterns on an insulating substrate or support member, techniques for forming such patterns, and assemblies using such a substrate. One such substrate is a circuit board having conductors which connect an electrical module to the circuit board to form a printed circuit board assembly.

As used herein, the term "electrical module" is intended to include any component, such as a semiconductor chip, a light emitting or detecting device, an emitting or detecting device of magnetic nature, a magnetic storage device, a capacitor, an inductor, a resistor, a crystal, a coil, a varactor, a thermistor, a resonator, transformers, and/or a connector that may be connected in an electrical circuit, an electro-optical circuit, an optical configuration, an electro-magnetic circuit and/or a magnetic configuration. The term "printed circuit board" is intended to encompass a support member that may be rigid or flexible, laminated or not, of any suitable composition, and that includes an electrically insulative surface on which a printed pattern of electrical conductors is provided. The term "printed pattern" is intended to encompass a pattern on a substrate formed by any suitable process, including, but not limited to, silk screen printing, photolithography, evaporation, plating, stenciling, ink writing, plasma deposition, sputtering, adhesives, or thin film or thick film techniques.

A printed circuit board having a semiconductor chip or other electrical module attached thereto shall be denoted as a printed circuit board assembly. It will be convenient to generally discuss the invention with particular reference to a printed circuit board assembly including a semiconductor chip of the surface mount or flip-chip type.

Such a chip typically has formed thereon an integrated circuit containing a number of electrical contacts (terminals) on one surface. The contacts are typically soldered or otherwise electrically connected to the conductors of the printed circuit board.

In the past, much effort has been focused on the use of conductors that are firmly adherent to the printed circuit board to minimize possible separation during use. Additionally, effort has also focused on maintaining the integrity of the conductor-chip interface to prevent failure at that connection. This arrangement usually operates satisfactorily. However, there are hostile environments, usually of high temperature and thermal excursions, where, during use, severe stresses cause the chip to separate from the printed circuit at or near the points of connections, that is, the solder joints. Such stresses can occur, for example, when the printed circuit board is used in an automobile.

It is desirable to have conductors of compositions which result in a printed circuit board assembly in which the electrical modules remain reliably connected to the printed conductors in hostile environments.

A printed circuit board assembly in accordance with the present invention is characterised by the features specified in the characterising portion of claim 1.

The present invention solves the foregoing problems by providing on a printed circuit board a printed pattern of controllably adherent conductors. The term "controllably adherent conductor" is used to describe a conductor which adheres to the circuit board during the manufacturing process, but which is free when being used to move (slide) along and/or lift off from the circuit board in response to stresses that may arise, for example, from thermal effects, to relieve such stresses.

This represents an approach that is the antithesis of the conventional approach mentioned above that has focused on maintaining the conductors firmly adherent to the circuit board. However, this approach does require a conductive layer for use as the controllably adherent conductor that has a degree of cohesive strength so that it does not fracture or become mechanically weak or electrically defective when separated from the circuit board.

Typically, the printed circuit board also includes a pattern of firmly adherent conductors to which first ends of the controllably adherent conductors are connected. Second ends of the controllably adherent conductors are typically soldered to an electrical module, such as a silicon integrated circuit chip having metallic external contacts (bumps) extending from a surface thereof.

The controllably adherent conductors and the electrical module can move to relieve stresses. This significantly reduces the possibility of breaking the bonds (typically solder joints) between the electrical module and the controllably adherent conductors. Accordingly, the reliability of the connections to the chip is improved.

Moreover, it is feasible to use a pattern of controllably adherent conductors alone where the pulling away of the conductors occurs only in high stress areas needing stress relief. In this case the firmly adherent conductors simply define bonding or contact pads.

In some instances a controllably adherent conductor may itself also serve as an electrical module. One example of such is a film resistor.

Controllably adherent conductors may be provided in various arrays and configurations, some of which are described below.

The controllably adherent conductors typically are prepared from a paste or ink which includes finely divided metal particles for conductivity and a binder. The latter is chosen to render the conductor adherent to a support member (substrate, circuit board) during processing, but to allow it to become detached from the substrate when subjected to stress during use.

Viewed in a broader aspect, the invention is directed to an assembly that includes a support member on which are supported controllably adherent conductors that include portions thereof which are free to move on and/or lift off the support member to relieve stresses on the conductors.

The present invention also provides specific techniques useful for forming such controllably adherent conductors. In particular, it involves the use of a localized layer, to be termed an inhibitor layer, intermediate between a circuit board and a portion of a conductive layer to achieve controlled adhesion for such portion of the conductive layer. Such controlled adhesion describes the property of a conductive layer overlying such inhibitor layer to lift off or slide along the printed circuit board in response to appropriate mechanical stress without fracture. Moreover, it includes both the situation where the inhibitor layer remains bonded to the circuit board and separates from the overlying conductive layer and the situation where the inhibitor layer remains bonded to the conductive layer and together they separate from the circuit board.

The localized use of an inhibitor layer allows one conductive layer to have one portion used as a firmly adherent conductor by placing it in direct contact with the circuit board and to have another portion used as a controllably adherent conductor by having it overlie an inhibitor layer.

The inhibitor layer is formed preferably by printing and subsequently firing a composition comprising essentially a mixture of a finely divided refractory material (for example, alumina or aluminium nitride) and a glass frit, suspended in an organic vehicle.

The glass frit is chosen to soften and wet both the surface of the circuit board and the refractory material at a temperature below the firing temperatures. This promotes bonding among the refractory particles and between the refractory particles and the surface of the circuit board. The refractory material chosen should have negligible chemical reaction with the conductor.

The present invention will now be described, by way of example, with reference to the following more detailed description taken in conjunction with the accompanying drawings, in which:-
Figure 1 is a cross-sectional view of a portion of a printed circuit board assembly in accordance with an embodiment of the present invention;
Figure 2 is a top view of a portion of the printed circuit board assembly shown in Figure 1;
Figure 3 is a top view of a modification of controllably adherent conductors of the printed circuit board assembly of Figure 1;
Figure 4 is a top view of another printed circuit board assembly in accordance with another embodiment of the present invention;
Figure 5 is a top view of another printed circuit board assembly in accordance with a further embodiment of the present invention;
Figure 6 is a top view of another printed circuit board assembly in accordance with a further embodiment of the present invention;
Figure 7 is a top view of another printed circuit board assembly in accordance with a further embodiment of the present invention;
Figure 8 is a flow chart of a typical process used to form the assemblies shown in Figures 1, 4, 5, 6, 7 and 9;
Figure 9 is a cross-sectional view of a portion of another printed circuit board in accordance with a further embodiment of the present invention;
Figure 10 is a graphical plot of the parameters of a furnace useful in forming the conductors on the printed circuit board assemblies of the above described figures;
Figure 11 is a cross-sectional view of a portion of another printed circuit board assembly in accordance with a further embodiment of the present invention; and
Figure 12 is a cross-sectional view of a portion of a printed circuit board assembly in accordance with a further embodiment of the present invention.

It is to be noted that the drawings are not to scale. Some background lines are not shown and some figures omit cross hatching to make the drawings easier to understand.

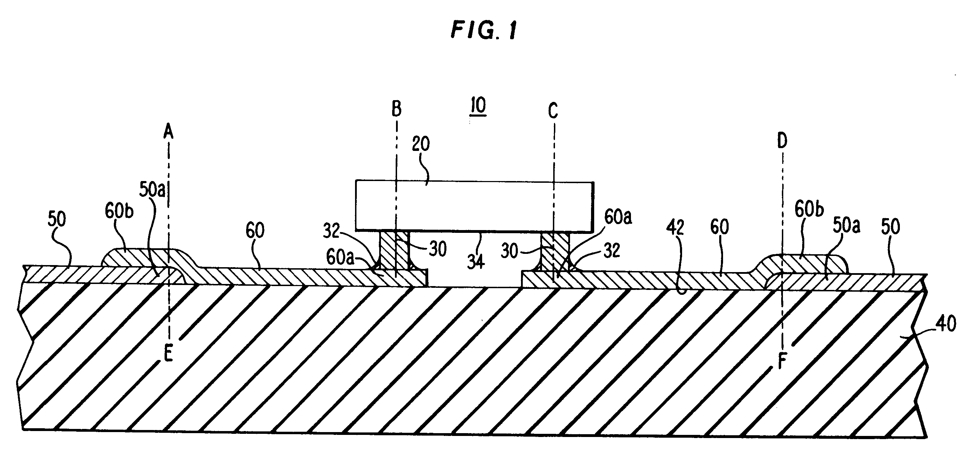

Referring now to Figure 1, there is shown a cross-sectional view of a portion of a printed circuit board (pcb) assembly 10 in accordance with an embodiment of the present invention. The pcb assembly 10 comprises an electrical module 20 and a support member (circuit board, substrate) 40 having an insulative top surface 42 on which are printed firmly adherent conductors 50 and controllably adherent conductors 60. In a typical embodiment, the electrical module 20 comprises an integrated circuit formed in a silicon chip of the flip chip or surface mount type, suitably covered by an insulating material (not shown) and having a plurality of external contacts 30 (for example, silver bumps) on a lower surface 34 thereof. These external contacts 30 are connected to electrodes (not shown) of various circuit elements (not shown) of the electrical module 20. The electrical module 20 may take various other forms as previously mentioned. It is to be noted that for illustrative purposes only, one electrical module 20 is shown. Typically, a printed circuit board assembly 10 contains a plurality of electrical modules 20 of different types.

Support member 40 is of a suitable insulating material, such as alumina (Al₂O₃). The conductive pattern formed by the conductors 50 and 60 and the electrical module 20 form an electrical circuit of the printed circuit board assembly 10. The firmly adherent conductors 50 may be conventional. They are typically formed by depositing a patterned layer of a suitable ink or paste that, after firing, provides a firmly adherent conductive pattern that is compatible for use with a pattern of controllably adherent conductors 60. Such a firmly adherent conductor 50 may include copper, nickel, silver, palladium, platinum and gold and/or alloys thereof and/or other suitable metals and/or compounds to make it conductive.

The electrical module 20 is secured to the firmly adherent conductors 50 by way of the controllably adherent conductors 60. Each external contact 30 of electrical module 20 is typically connected to one end 60a of a controllably adherent conductor 60 by means of a bond, such as a solder joint 32. The nature of these controllably adherent conductors 60 will be discussed more fully below. The bond could be formed in various other ways, including use of a conductive adhesive epoxy or other conductive adhesive material, or the bond could be a weld. The other end 60b of the controllably adherent conductor 60 is bonded or fused in any suitable fashion to a contact portion 50a, typically formed by an end of a firmly adherent conductor 50. All but the other end 60b of each controllably adherent conductor 60 is controllably adherent to the top surface 42 so that it can flex and lift off the top surface 42 to relieve stresses on solder joints 32. Moreover, because the external contacts 30 of the electrical module 20 are bound only to the ends 60a of controllably adherent conductors 60, and the electrical module 20 is not itself bonded to top surface 42, the electrical module 20 can also move along or lift off the top surface 42 of the support member 40 to help relieve stresses at the solder joints 32. As a result, pulling apart forces are significantly reduced at each solder joint 32. The stresses that occur may produce either tensile or compressive stresses that are substantially completely absorbed due to the flexible nature in which electrical module 20 is mounted to provide a substantially stress-free and fatigue-free arrangement.

Moreover, as will be discussed more fully later, because the controllably adherent conductors 60 are free to move, it is feasible to design the lengths of the controllably adherent conductors 60 so that their changes in length relative to the changes in the lengths of the relevant portion of the (alumina) support member 40 and of the electrical module 20 balance over an operating temperature range to further relieve stresses in the solder joints 32.

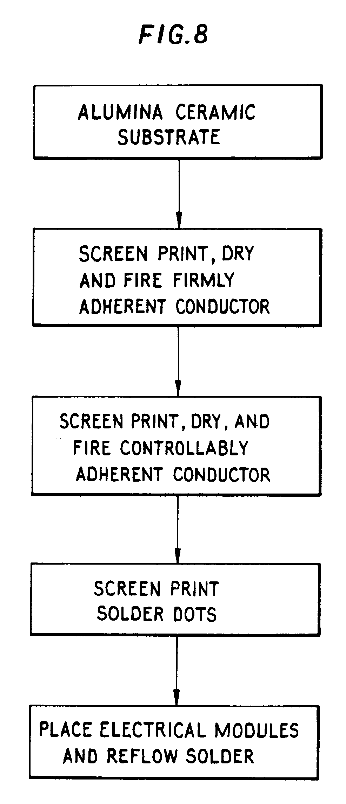

Referring now to Figure 8, there is shown a flow chart of a typical process for preparing the pcb assembly 10 shown in Figure 1. As indicated, a ceramic printed circuit board, typically of alumina, is used as the support member of substrate 40.

Firmly adherent conductors 50 are then deposited on the support member 40. This is done in conventional fashion and generally involves first screen printing a suitably patterned layer and then drying and firing the layer. The layer as printed, is of an ink or paste that will form a firmly adhering conductive layer. In a preferred embodiment, the layer deposited is of a material commercially available from Dupont Electronics and known as Dupont 9161. It basically comprises conductive copper particles, adhesion promoters and a screening agent. Suitable other materials are available from other sources. After printing, the drying and firing is done in the manner prescribed by the supplier to sinter the copper particles together into a conductive layer which firmly adheres to the support member 40.

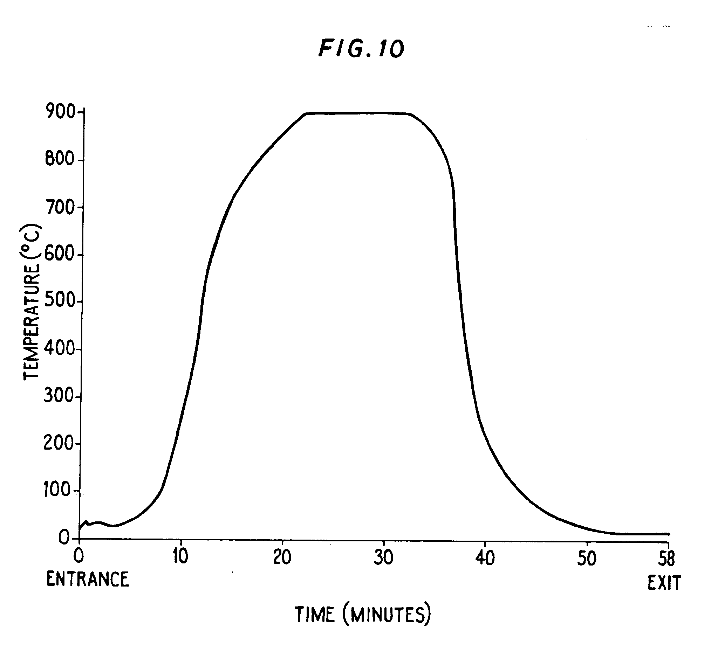

Referring now to Figure 10, there is shown a graphical plot of the parameters of a furnace (not shown) that can be used for the firing process. In the plot, the y axis shows temperature in degrees C of successive zones of the furnace and the x axis shows elapsed time in minutes as a workpiece (for example, a support member 40 with ink patterns which will become conductors 50 and/or 60) moves along a belt (not shown) through the various temperature zones existing within the furnace. The terms "ENTRANCE" and "EXIT" shown in Figure 10 indicate the workpiece entering and exiting, respectively, the furnace. As is seen, the workpiece takes slightly more than twenty minutes to reach the maximum temperature of about 900°C during which time the organic vehicle in the original paste or ink is being removed. It then takes about ten minutes to pass through the furnace zone at this peak temperature during which the copper particles are sintered into a conductive layer. Finally, it is allowed to cool gradually to room temperature over about a twenty minute period to reduce thermal shock. Of course, the optimum parameters are usually a function of the particular paste or ink being used.

Next, the controllably adherent conductors 60 are similarly formed by screen printing, drying and firing a layer of suitable composition.

To avoid the need for separate furnaces, it is advantageous to choose compositions for use in forming both the firmly adherent conductors 50 and the controllably adherent conductors 60 that can be processed in the same way. When this is done, the drying and firing of the composition used to form controllably adherent conductors 60 are carried out in the same manner as described previously for the firmly adherent conductors 50 as discussed with reference to Figure 10. The controllably adherent conductors 60 are formed to extend between the firmly adherent conductors 50 and where the external contacts 30 of the electrical modules 20 are to be positioned.

Special compositions are used to form controllably adherent conductors 60 to provide the desired controllable adherent properties and to be compatible for use with firmly adherent conductors 50.

Several compositions are presently of particular interest for use to form controllably adherent conductors 60 of the kind described. These compositions have the advantage that they have the desired compatibility with firmly adherent conductors 50.

The first composition, which is preferred for some applications, includes by weight about 88.5 percent of a conductor, about 10 percent of a suitable screening agent, and about 1.5 percent of a binder. The conductor is finely divided copper powder with an average particle size of between 1 and 2 microns. The specific screening agent is a mixture of about 90 percent by weight of a solvent, typically TEXANOL^{TM} (believed to be 2,2,4 Trimethyl 1,3 Pentanedio Monoisobutyrate), and the remainder of a resin, typically ethyl cellulose grade N-50, both of which are available commercially. The binder consists essentially of bismuth oxide (Bi₂O₃) which serves to promote both adhesion of the layer of controllably adherent conductor 60 to the support member 40 during processing and cohesion of the copper particles after firing.

Too large an amount of the binder undesirably increases adhesion to the support member 40 and makes it difficult for the controllably adherent conductors 60 to lift off the top surface 42 of the support member 40 to accommodate mechanical stresses. Too little of the binder results in nonadherence immediately after firing, preventing any subsequent processing. Typically, the binder should be at least 0.05 percent and no more than 5.0 percent of the composition, although if the binder is chosen to be one largely lost during firing, or is not a very effective adhesion promoter, larger amounts initially may be feasible. The appropriate limits can be expected to be dependent on the characteristics of the metal powder employed.

The screening agent should be chosen to facilitate the screen printing, and various other agents should be suitable. Moreover, the fraction of the solvent in the screening agent typically is between 85 and 98 percent.

A second composition, which is also found particularly useful, differs only in the composition of the binder, which now consists essentially of equal parts by weight of bismuth oxide and cuprous oxide, milled together. Here the cuprous oxide appears to serve primarily to promote adhesion.

Another composition that proved useful included by weight about 89 percent powdered copper, about one percent of a frit as the binder, and about 10 percent of the screening agent described above in which the frit included by weight about 70.0 percent bismuth oxide (Bi₂O₃), 15.6 percent lead oxide (PbO), 4.5 percent lead fluoride (PbF₂), 6.6 percent silicon dioxide (SiO₂), 0.6 percent aluminum oxide (Al₂O₃), and 2.7 percent boron oxide (B₂O₃).

The components of this frit by weight could be varied with the Bi₂O₃ between 0-73 percent, the PbO between 15-60 percent, the PbF₂ between 4-12 percent, the SiO₂ between 5-25 percent and the Al₂O₃ between 0.5-2.5 percent and the B₂O₃ between 2-10 percent. This frit can be also viewed as a mixture of bismuth oxide (0-70 percent) and the remainder a frit of the following composition by weight, 50-65 percent PbO, 5-15 percent PbF₂, 20-30 percent SiO₂, 0-5 percent Al₂O₃, and 5-15 percent B₂O₃ with a typical composition of this frit being by weight 55.4 percent PbO, 9.4 percent PbF₂, 23.5 percent SiO₂, 2.1 percent Al₂O₃ and 9.6 percent B₂O₃.

Two other compositions that proved successful included by weight 89.25 and 89.5 percent copper powder, respectively, 10 percent of the screening agent described earlier and the balance a frit that included by weight 60-75 percent PbO, 10-25 percent SiO₂, 5-30 percent B₂O₃ and 0-10 percent Al₂O₃. One embodiment which proved successful included a glass frit approximately by weight 66.6 percent PbO, 22.4 percent SiO₂, 8.7 percent B₂O₃ and 2.3 percent Al₂O₃.

These examples demonstrate the wide range of mixtures that can be used as the binder in the compositions to achieve the controllably adherent conductor 60 needed.

In general, the compositions especially useful for forming controllably adherent conductors 60 comprise between 75 and 92 percent finely divided copper powder, with an average particle size of between about 0.5 and 5.0 microns, 7.5 to 20 percent of a screening agent, and the remainder essentially of a binder to promote adequate cohesion and controllable adhesion of the kind described. In a preferred range, the copper has an average particle size between 1 and 2 microns and comprises between 85 and 90 percent of the mixture.

A variety of other compositions should be suitable including some that use other kinds of conductive particles, such as silver, palladium, nickel, platinum and gold and/or alloys thereof. Moreover, in some instances, it may prove advantageous to include a surfactant to improve wetting. The composition should result in controllably adherent conductive layers having characteristics compatible with those of the firmly adherent conductive layers.

Next, optionally there may be printed, dried and fired other layers that serve special roles, such as thick film resistors. In some instances, in order to provide different values of thick film resistors, two or more resistive compositions are included that require separate processing. This step may be repeated as needed to deposit all such thick film resistors.

Finally, as indicated in Figure 8, the electrical module 20 of the pcb assembly 10 is electrically connected to the controllably adherent conductors 60.

Typically, this first includes printing solder dots on the ends 60a of controllably adherent conductors 60 where such ends 60a are to be attached to the external contacts 30 of the electrical module 20. This can be done in conventional fashion. Advantageously, the solder paste used to form the solder dots comprises a 25/75 tin-lead solder. After the solder paste is deposited, the electrical module 20 is appropriately positioned to have its external contacts 30 aligned with the solder dots. Then the pcb assembly 10 is heated to a temperature to melt and reflow the solder and then cooled to solidify resulting solder joints 32 between the external contacts 30 and the ends 60a of controllably adherent conductors 60.

It should be apparent that it would be feasible, if desired, to print or form the controllably adherent conductors 60 before printing or forming the firmly adherent conductors 50.

In some instances, it may be feasible to use a single furnace operation to form both patterns of conductors simultaneously.

When the pcb assembly 10 thus prepared is placed in operation and subjected to sufficiently high stresses, these stresses are absorbed by the controllably adherent conductors 60, which lose their adhesion to the support member 40 and then are free to move along and/or lift off the top surface 42 of the subject matter 40.

In an embodiment of pcb assembly 10 in accordance with the invention: the external contacts 30 of electrical module 20 are made of silver and each has a height in the range of 0.018 to 0.076 mm (0.0007 to 0.003 inches) and a diameter of about 0.153 mm (0.006 inches); the electrical module 20 is square in shape and has dimensions in the range of 4.57 to 7.62 mm (0.180 to 0.3 inches); and the solder joints 32 are formed using a 25/75 tin lead solder; each of controllably adherent conductors 60 has a width of 0.127 to 0.254 mm (0.005 to 0.01 inches), a length of 1.02 to 3.81 mm (0.04 to 0.150 inches) and a thickness of 0.008 to 0.02 mm (0.0003 to 0.0008 inches). Various other parameters, such as the thickness of controllably adherent conductors 60 in the range of 0.008 to 0.025 mm (0.0003 to 0.001 inches), are, of course, feasible.

The dimensions of the controllably adherent conductors 60 advantageously are designed to provide optimal performance of their function with a minimal amount of conductor material. Various conductor configurations are feasible and typical configurations are described below.

Referring again to Figure 1, in one presently preferred design, the thermal expansion rate (change in length/unit change in temperature) of dimension A to D along the controllably adherent conductors 60 and the electrical module (chip) 20 is equal to that of the dimension of E to F along the support member 40. The rate of expansion is determined by the thermal expansion coefficient of the type of material and the length of material that is of concern. Thus, if the rate of expansion of distance A to B, B to C and C to D are added, they become that of A to D, which should be equal to the rate of expansion of E to F. For a given pcb assembly 10, the dimension B to C is fixed by the electrical module 20 design. However, the dimensions A to B and C to D can be made of any desirable length. By adjusting the length of A to B and C to D (normally these would be equal), the sums of the rates of all three components can be made equal to that of E to F. One pcb assembly 10, which was built on an alumina substrate (support member 40), had a length (A to B) = (C to D) = 11.18 mm (0.44 inches) and used an electrical module 20 having a square dimension of 7.21 mm (0.284 inches) (B to C).

The controllably adherent conductors may be formed in various shapes as desired, since the shape, while important, is not critical.

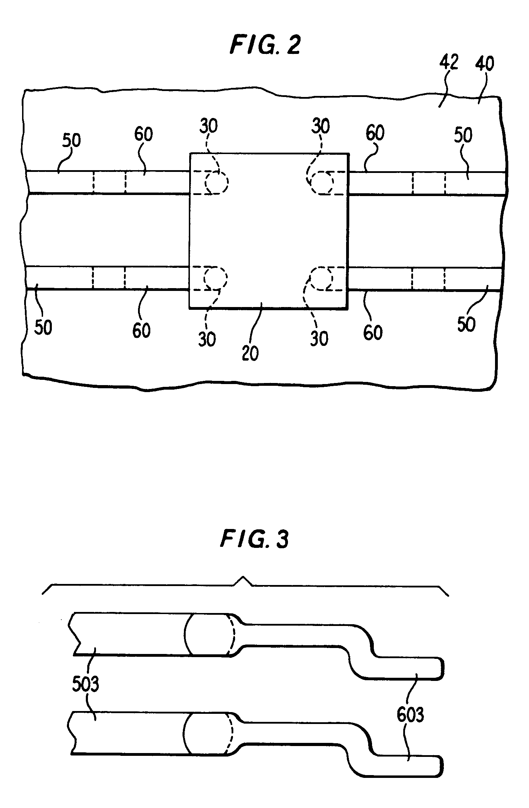

Referring now to Figure 2, there is shown a top view of a portion of pcb assembly 10 which shows the controllably adherent conductors 60 as straight.

Referring now to Figure 3, there is shown a top view of controllably adherent conductors 603 which have an S-shaped bend to reduce stress at the joint between a controllably adherent conductor 603 and a firmly adherent conductor 503. Conductors 503 and 603 are the same kind of conductors as conductors 50 and 60, of Figure 1 except for the bend in each controllably adherent conductor 603.

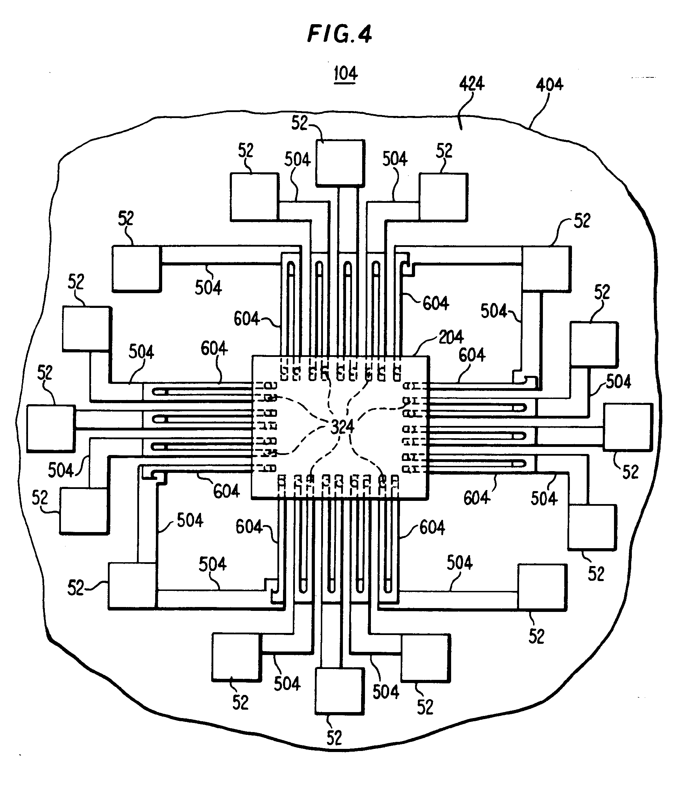

Referring now to Figure 4, there is shown a top view of a printed circuit board (pcb) assembly 104. Pcb assembly 104 is similar to pcb assembly 10 of Figure 1, and all corresponding parts thereof have the same reference number with a "4" added thereafter. One end of each of firmly adherent conductors 504 mechanically and electrically contacts a bonding (contact) pad 52 which firmly adheres to top surface 424 of support member 404. Controllably adherent conductors 604 are straight. Each of controllably adherent conductors 604 is shown having two parallel fingers. This configuration is useful for testing, but a single finger conductor 604 is typically preferable. It is to be noted that the firmly adherent conductors 504 can be eliminated with controllably adherent conductors 604 then being connected directly to bonding pads 52. Still further, bonding pads 52 can be modified in shape and size and brought out to an edge of support member 404 to serve as the male portion of a connector assembly (not shown) that is adapted to plug into a female portion (not shown) of the connector assembly.

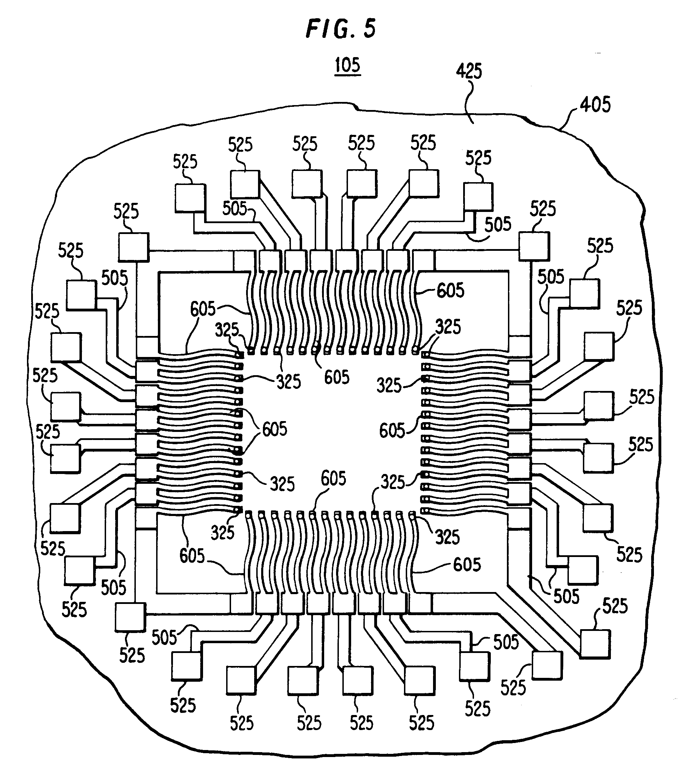

Referring now to Figure 5, there is shown a top view of a printed circuit board assembly 105. Pcb assembly 105 is similar to pcb assembly 10 in Figure 1 and all corresponding parts thereof have the same reference number with a "5" added thereafter. Pcb assembly 105 is also similar to pcb assembly 104 of Figure 4 except that controllably adherent conductors 605 are S-shaped and are connected to firmly adherent conductors 505 which are connected to bonding (contact) pads 525. An electrical module to which controllably adherent conductors 605 are connected is not shown.

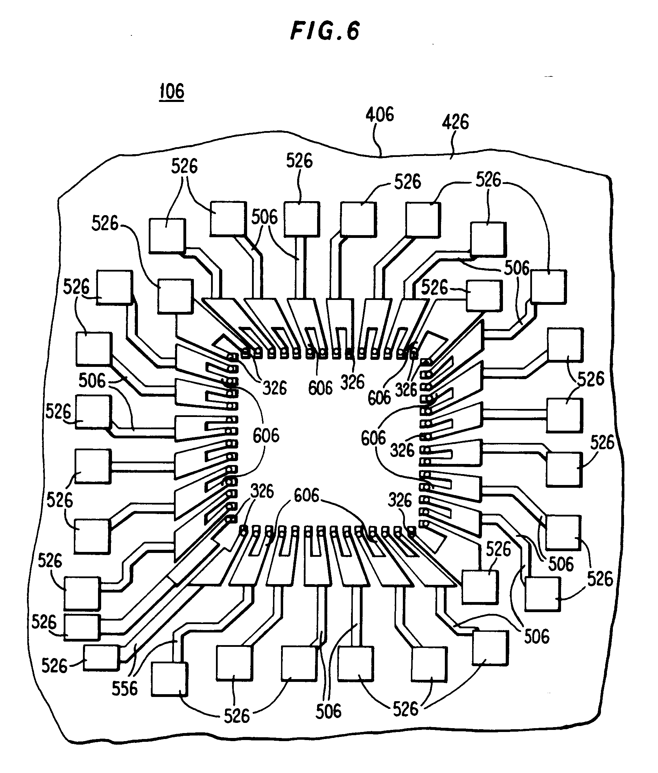

Referring now to Figure 6, there is shown a top view of a printed circuit board assembly 106. Pcb assembly 106 is similar to pcb assembly 10 of Figure 1 and all corresponding parts thereof have the same reference number with a "6" added thereafter. Pcb assembly 106 is also similar to pcb assembly 105 of Figure 5 except that the controllably adherent conductors 606 are angled with respect to the electrical module (chip) (not shown) they contact. Printed circuit board assembly 106 allows the chip to rotate so as to relieve stress where the chip is soldered to controllably adherent conductors 606.

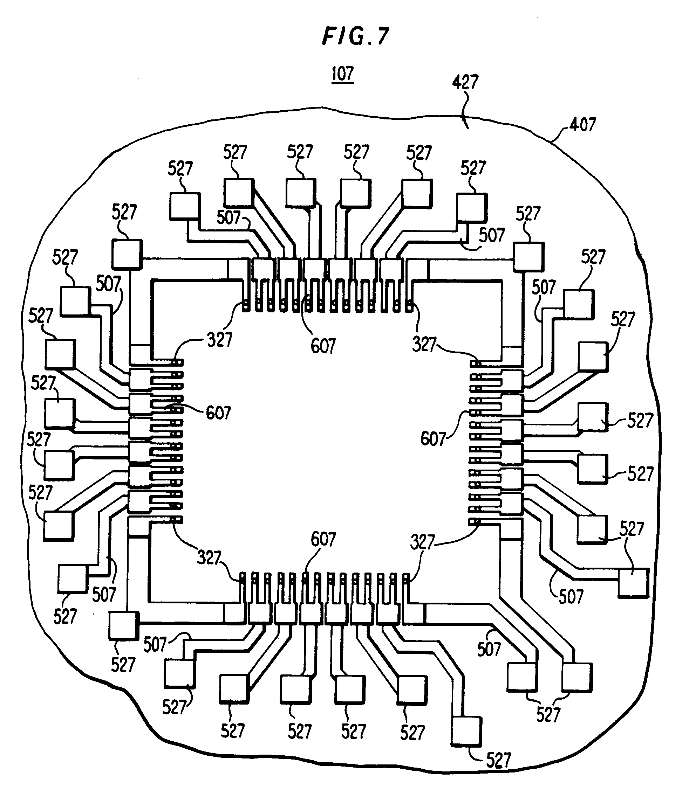

Referring now to Figure 7, there is shown a top view of a printed circuit assembly 107. Pcb assembly 107 is very similar to pcb assembly 10 of Figure 1 and to pcb assembly 104 of Figure 4 except the corresponding parts thereof have a "7" added to the last digit of the reference number. In this case, there is no provision for the rotation of the electrical module (chip) (not shown) to accommodate movement in the positions of its external contacts (not shown) and the solder joints (not shown). Instead, the length of the pairs of controllably adherent conductors 607 are chosen so that over a preselected operating temperature range, the changes in position of their first ends are such as to compensate for the changes in position of the external contacts (not shown). As a result, stresses on the solder joints are significantly limited and the reliability of pcb assembly 107 is significantly increased.

It should be apparent that the invention is largely independent of the specific nature of the electrical module connected into the printed circuit. It could be simply any circuit component as listed above that has contacts on one surface by which the circuit component is to be connected. It may also be a connector whose various pins are to be connected to ends of the controllably adherent conductors.

Additionally, as was mentioned earlier, the term "printed circuit board" can encompass a wide variety of forms since the nature of the substrate on which the controllably adherent conductors are deposited need only be compatible with the desired controllable adhesion of the conductive layer deposited.

In particular, the substrate or support member may even be a semiconductor wafer on which are deposited controllably adherent conductors for connecting components therein. Additionally, the substrate or support member may be a first semiconductor chip on top of which is connected a second semiconductor chip by way of controllably adherent conductors which are free to move on and/or away from a surface of the first chip.

Moreover, the invention may be feasible with superconductive circuits in which either the controllably adherent or firmly adherent conductors are superconductors.

Similarly, it should be apparent that the specific nature of the circuit board that serves as the substrate or support member is not critical. In particular, the circuit board need not be rigid but may be of a flexible kind. Also, it need not be ceramic but may be of any suitable composition that is compatible with controlled adhesion.

In some instances, it may prove desirable to provide a resilient coating over the surface of the electrical module including its contacts, to cushion any movement of the electrical module. In other instances, particularly when an electrical module is of relatively large mass, it may be desirable to restrain its movement.

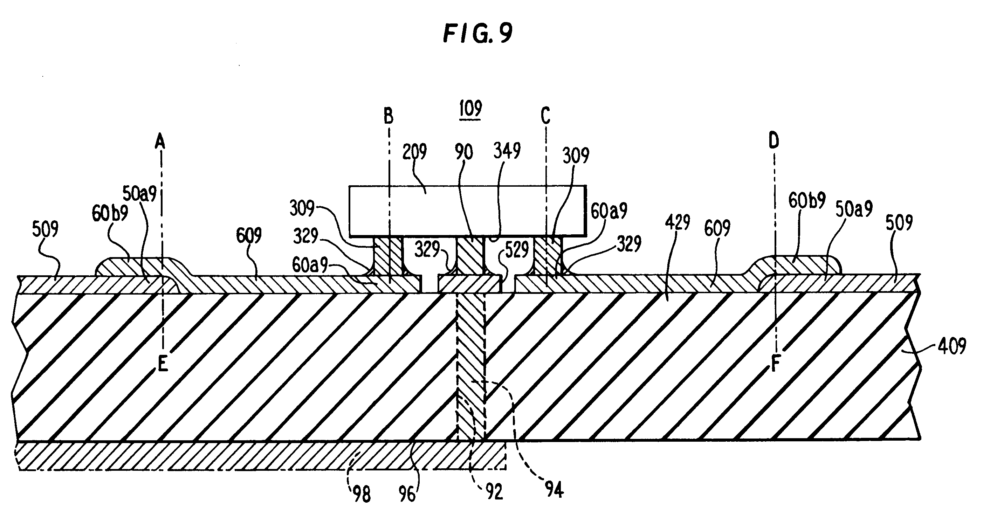

Referring now to Figure 9, there is shown a cross-sectional view of a portion of a printed circuit board assembly 109 that is very similar to pcb assembly 10 of Figure 1 and the corresponding parts thereof have a "9" added to the last digit of the reference number. Pcb assembly 109 has an electrical module 209 which has a plurality of external contacts (bumps) 309 and has an essentially centrally located contact (bump) 90 which is soldered via a solder joint 329 to a firmly adherent conductive contact region (bonding pad 529) on the top surface 429 of the support member 409. This results in the centre portion of electrical module 209 being essentially fixed to the top surface 429 of support member 409. Portions of electrical module 209 other than the centre portion thereof are free to move to relieve stress as are controllably adherent conductors 609.

A passage 92 (shown in dashed lines) can be formed through support member 409 and a conductor 94 can be passed therethrough to an opposite surface 96 of support member 409. A firmly adherent conductor 98 (shown in dashed lines) is attached to one end of conductor 94 which has a second end attached to bonding pad 529. Thus support member 409 can be used as a double (two) sided printed circuit board. A central portion of support member 409, the portion shown as having centrally located contact 90, could have centrally located contact 90 deleted and could be instead adhesively attached to the top surface 429 by a heat conducting and electrically non-conducting epoxy or other material or compound (all not shown) to help conduct heat away from electrical module 209. This added heat dissipation mechanism allows for the use of larger chips with associated higher power dissipation than might be otherwise possible. In some instances the epoxy could be electrically conductive and could be used to bring electrical signals and/or power to the electrical module 209. A plurality of contacts, each like centrally located contact 90, could be substituted for centrally located contact 90. These substituted contacts would be attached to central portions of electrical module 209 and would serve to enhance the mechanical integrity of pcb assembly 109 during vibration of same. The substituted contacts could also serve to bring electrical signals and/or power to electrical module 209.

It should also be apparent that the printed circuit board may support one or more electrical modules with some free to move on the circuit board in the manner discussed and with others that are fixed in place in conventional fashion.

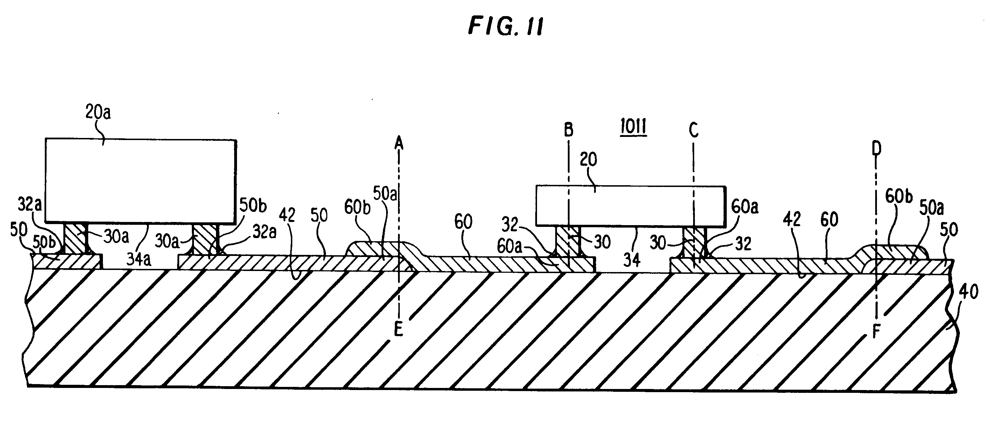

Referring now to Figure 11, there is a cross sectional view of a portion of a printed circuit board assembly 1011. Pcb assembly 1011 is essentially the same as pcb assembly 10 of Figure 1 except that it comprises a second electrical module 20a that is attached (soldered) via external contacts (for example, silver bumps) 30a by soldered joints 32a to portions 50b of firmly adherent conductors 50. Such attachment is typically used when electrical module 20a is sufficiently heavy such that if it were attached to controllably adherent conductors 60 it could endanger the integrity of the controllably adherent conductors 60 and cause them to crack and/or break. The components of pcb assembly 1011 which are very similar or identical to those of pcb assembly 10 of Figure 1 have the same reference number. Electrical modules 20a advantageously are fabricated from materials which have a coefficient of thermal expansion which is close to that of support member 40 and therefore solder joints 30a will experience little stress as a result of thermal changes. Typically, thick or thin film resistors printed on a circuit board would be connected to firmly adherent conductors 50 as would a chip that is to be wire bonded to the circuit board.

If one composition is used to form all conductors, differences in adhesion to the circuit board can be achieved by modifying portions of substrate on a microscopic scale to alter adhesion whereas other portions of the circuit board are left in the normal state. Another technique which uses one composition to form both firmly adherent and controllably adherent conductors on a common circuit board is described below.

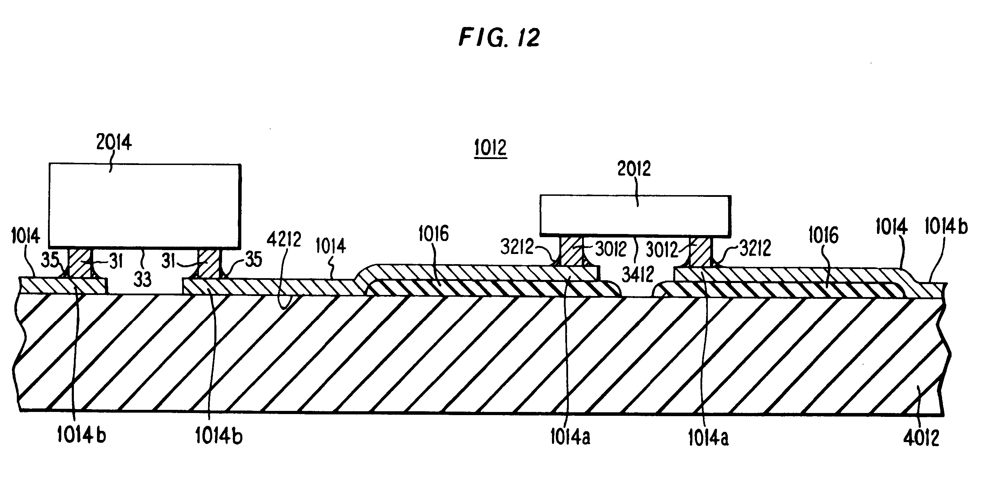

Referring now to Figure 12, there is shown a cross sectional view of a portion of a printed circuit board assembly 1012 in accordance with a further embodiment of the present invention. The pcb assembly 1012 comprises electrical modules 2012 and 2014 and a support member (circuit board, substrate) 4012 having an insulative top surface 4212 on which are printed (formed) conductors 1014 having portions 1014a which are separated from top surface 4212 by an inhibitor layer 1016 and having portions 1014b which make direct contact with top surface 4212. The portions 1014a of conductors 1014 where the inhibitor layer 1016 lies intermediate between top surface 4212 and the conductors 1014 are controllably adherent. The portions 1014b of conductors 1014 where the conductor 1014 is in intimate contact with the top surface 4212 are firmly adherent.

The electrical module 2012 has external contacts 3012 thereof (which are attached to a bottom surface 3412 of module 2012) bonded, typically by solder joints 3212, to the portions 1014a of conductors 1014. As a result, the portions 1014a of conductors 1014 are controllably adherent and are able to move along and/or lift off top surface 4212 of the support member 4012 as needed to relieve mechanical stresses on the solder joints 3212.

The electrical module 2014 has external contacts 31 thereof (which are attached to a lower surface 33 thereof) bonded, typically by solder joints 35 to (firmly adherent) portions 1014b of conductors 1014. Electrical module 2014 is typically attached to (firmly adherent) portions 1014b of conductors 1014 because in some cases it is sufficiently heavy such that if attached to portions 1014a it could endanger the integrity of portions 1014b of conductors 1014 and cause same to crack and/or break.

In a typical embodiment the electrical module 2012 comprises an integrated circuit formed in a silicon chip of the flip chip or surface mount type, suitably covered by an insulating material (not shown) and having a plurality of external contacts 3012 (for example, silver bumps) on the lower surface 3412 thereof. These external contacts 3012 are connected to electrodes (not shown) of various circuit elements (not shown) of the electrical module 2012. The electrical module 2012 may take various other forms as previously mentioned. It is to be noted that for illustrative purposes only one electrical module 2012 is shown. Typically a printed circuit board assembly 1012 contains a plurality of electrical modules 2012 and 2014 of different types. It may, however, contain just one or more of electrical modules 2012.

The conductive pattern formed by the conductors 1014 and the electrical modules 2012 and 2014 form an electrical circuit of the printed circuit board assembly 1012. The conductors 1014 are typically formed by depositing a patterned layer of a suitable ink or paste that, after firing, provides a conductive pattern. Such conductors 1014 may include copper, nickel, silver, palladium, platinum and gold and/or alloys thereof and/or other suitable metals and/or compounds to make them conductive.

In a preferred embodiment, the conductive layer was formed by the use of Dupont 9161, previously described, which comprises essentially finely divided copper particles, a screening agent and adhesion promoters.

Each external contact 3012 of electrical module 2012 is typically connected to one part of a portion 1014a of a conductor 1014 by means of a bond, such as a solder joint 3212. All of the solder joints 3212 and 35 between both electrical modules 2012 and 2014 and the conductors 1014 could be formed in various other ways, including use of a conductive adhesive epoxy or other conductive adhesive material, or could be welds.

In accordance with the invention, the various materials involved are chosen such that mechanical stresses on the solder joints 3212 are significantly relieved by the ability of the solder joints 3212 to move relative to the support member 4012. The relative motion can be achieved in two basic fashions.

In the first, the portions 1014a of conductors 1014 remain intimately bonded (attached) to portions of the inhibitor layer 1016 therebelow and together they move along and/or lift off support member 4012. This approach has the potential of increasing the mechanical strength of the composite layer portions.

In the other approach, the portions of the inhibitor layer 1016 under portions 1014a of conductors 1014 remain in place intimately bonded to the support member 4012 while the portions 1014a of the conductors 1014 are free to move along or lift off the inhibitor layer 1016.

A conductive layer printed on a circuit board depends for its adhesion to the circuit board on a reaction between the surface of the board and the ingredients in the composition (for example, ink) used to print the conductive layer. For controlled adhesion of the kind desired, it is necessary to partially stifle this reaction so that the layer can separate from the circuit board in response to mechanical stress.

When the ink being used to print a conductive layer includes adhesion promoters that react and insure firm adhesion where applied directly to a substrate, such as the surface of a printed circuit board, an inhibitor layer must serve to restrain such reaction.

There are several possible approaches to providing such an inhibitor layer.

A first approach is to use an inhibitor layer that essentially includes only an organic vehicle that has poor burn-out characteristics under the firing conditions used, such as the case where a nitrogen atmosphere is used for firing a conductive layer (for example, copper), so that little reaction is created with the substrate for promoting adhesion because excessive organics render the binders in the ink ineffective.

A second approach involves using as the inhibitor layer a film including essentially only an organic vehicle that has excellent burn-out to lessen a chance of reaction between the adhesive promoters and the substrate. This approach is suitable in cases where no residual organics on the substrate are tolerable.

A third approach is to form the inhibitor layer by a composition that consists essentially of a finely divided refractory material (for example, alumina) suspended in an organic medium.

A fourth and presently preferred approach is to form the inhibitor layer by a composition that has a finely divided refractory material and a glass frit suspended in an organic medium. As mentioned earlier, the glass frit is chosen to soften and wet both the surface of the circuit board and the refractory material, typically alumina, at a temperature below the firing temperatures. This promotes bonding among the refractory particles and between the refractory particles and the surface of the circuit board. The refractory material, preferably an oxide such as alumina, should have negligible reaction with the conductive layer to be deposited over the inhibitor layer.

In a specific embodiment of the invention in accordance with the last approach, the inhibitor layer 1016 was formed by printing a composition comprising by weight essentially about 80 percent a screening agent, about 10 percent a glass frit and about 10 percent alumina (Al₂O₃). Moreover the glass frit consisted by weight essentially of about 66.6 percent lead oxide (PbO), 22.4 percent silicon dioxide (SiO₂), 8.7 percent boron trioxide (B₂O₃) and 2.3 percent alumina (Al₂O₃).

Other suitable compositions for use in printing the inhibitor layer 1016 included by weight: about 50 percent screening agent, 17 percent glass frit, and 33 percent alumina; and about 40 percent screening agent, about 20 percent glass frit and about 40 percent alumina.

In these compositions the screening agent used comprised by weight about 25 percent of a resin, typically Elvacite 2046, a product of E. I. Dupont de Nemours Inc. dissolved in a solvent, such as TEXANOL^{TM}, a product that has been previously described, and the glass frit used comprised by weight between 60-75 percent PbO, 10-25 percent SiO₂, 5-30 percent B₂O₃ and 0-10 percent Al₂O₃. Various glass frit compositions other than the specific composition described can be used consistent with the requirements mentioned above. Alternatively, certain oxides, such as bismuth oxide (Bi₂O₃), which serve essentially the same function as the glass frit, can be substituted for the glass frit. These certain oxides are denoted as "oxide binders".

The thickness of the inhibitor layer 1016 is desirably as thin as can be printed reliably to minimize topographical changes in the conductors 1014. The surface area of the inhibitor layer 1016 is sufficient to encompass the regions desired for controlled adhesion but need not necessarily be patterned to be congruent in width and length with the conductive layer. The thickness of the inhibitor layer 1016 is typically in the range of 0.0025 to 0.025 mm (0.0001 to 0.001 inches) with a preferred range of 0.005 to 0.013 mm (0.0002 to 0.0005 inches). A blanket inhibitor layer 1016 could be used instead of separated inhibitor layers for each portion 1014a of the conductors 1014 which are to be characterized by controlled adhesion. The thickness of the conductors 1014 is typically in the range of 0.0076 to 0.025 mm (0.0003 to 0.001 inches) with a preferred range of 0.01 to 0.02 mm (0.0004 to 0.0008 inches). Generally, the thickness of the inhibitor layer 1016 after firing can be controlled both by the thickness of the layer printed and the percentage of the inorganic solids (the glass frit and the refractory materials) in the composition printed. Generally, such solids should be between 5 and 85 percent by weight of the composition. The degree of adhesion is determined primarily by the ratio of the amount of glass frit and the amount of refractory materials in the composition. This ratio most advantageously is in the range between 0.1 and 2.0.

The printed patterns can be formed in two basic ways.

The presently preferred way is first to print the composition that provides the inhibitor layer and merely to dry this layer without firing. Then there is printed and dried the composition that provides the conductive layer. The resultant is then heated for firing both layers in the same heating cycle. The heating cycle used is that recommended by the manufacturer for Dupont 9161 composition and basically is that previously discussed with reference to Figure 10.

Alternatively, depending on the nature of the selected conductor and inhibitor, the first layer could be both dried and fired before deposition of the second layer.

Examples of refractory oxides that can be used instead of Al₂O₃ are SiO₂, ZrO₂ and TiO₂. A combination of any of these four refractory oxides could also be used.

As mentioned previously, other refractory materials, such as nitrides, should be useful in place of the refractory oxides if compatible with the glass frit.

Various other compositions for both the inhibitor layer and the conductive layer can be expected to be useful, consistent with the principles set forth including particularly various other screening agents and amounts of screening agents.

Moreover, the principles of controlled adhesion that have been discussed above in the context of electrical application to printed circuit board technology are not limited to such application. The principles can be extended to applications in which the controllably adherent conductors serve primarily mechanical rather than primarily electrical roles. The principles can be further extended to applications in which non-electrically conductive members (runners), which have essentially the same controlled adhesion as the controllably adherent conductors, are used in mechanical roles.

## Claims

1. A method of forming a printed circuit board comprising the steps of printing and drying on a support member (4012) a patterned layer (1016) of a first composition; and printing and drying on the support member a patterned layer (1014) of a second composition including portions overlying portions of the patterned layer of first composition; characterised by firing the two patterned layers for forming on the support member a first pattern of firmly adherent conductors from the patterned layer of the second composition in intimate contact with the support member and a second pattern of controllably adherent conductors where portions of the patterned layer of the second composition overlie portions of the patterned layer of the first composition, the controllably adherent conductors being adhered to the support member and/or the patterned layer of the first composition during firing, but being capable of lifting relative to the support member during operation of the printed circuit board.

2. A method as claimed in Claim 1, wherein the first composition comprises essentially a screening layer, glass frit, and alumina; and the second composition comprises essentially a screening agent, a metallic powder, and adhesion promoters.

3. A method as claimed in Claim 2, wherein the metallic powder is copper powder.

4. A printed circuit board comprising a support member (40) having an insulative top surface (42); a plurality of firmly adherent conductors (50) firmly secured to the top surface of the support member; and a plurality of controllably adherent conductors (60) each having a first end (60b) in electrical contact with a corresponding firmly adherent conductor, an intermediate portion, and a second end (60a) for electrical connection to an electrical module (20), the intermediate portion of each controllably adherent conductor between its first and second ends being adhered to the support member during manufacture of the printed circuit board; characterised in that at least the intermediate portion of the controllably adherent conductors (60) can lift relative to the top surface (42) of the support member (40) when the printed circuit board is operating and exposed to stresses.

5. A printed circuit board as claimed in Claim 4, wherein the second end (60a) of each controllably adherent conductor (60) can also lift to relieve stresses.

6. A printed circuit board as claimed in any one of Claims 1 to 5, wherein the firmly adherent conductors are solely in the form of contact pads (52).

7. A printed circuit board as claimed in any one of Claims 1 to 6, wherein each controllably adherent conductor and its corresponding firmly adherent conductor are integrally formed in one piece (1014).

8. A printed circuit board as claimed in Claim 7, comprising an inhibitor layer (1016) on the top surface (4212) of the support member (4012), wherein the intermediate portion and the second end of each controllably adherent conductor is positioned on the inhibitor layer, the inhibit layer remaining attached to the top surface or attached to the controllably adherent conductor during lifting of the controllably adherent conductor.

9. A printed circuit board as claimed in Claim 8, wherein the inhibitor layer (1016) is formed from a composition including a screening agent, a refractory material, and a glass frit.

10. A printed circuit board as claimed in Claim 9, wherein the ratio by weight of the glass frit to the refractory material is between 0.1 and 2.0.

11. A printed circuit board as claimed in Claim 9 or Claim 10, wherein the weight of the glass frit and the refractory material is between 5 and 85 per cent of the weight of the composition.

12. A printed circuit board as claimed in any one of Claims 9 to 11, wherein the refractory material is an oxide.

13. A printed circuit board as claimed in Claim 12, wherein the refractory material is one of or a combination of Al₂O₃, SiO₂, ZrO₂ and TiO₂.

14. A printed circuit board as claimed in any one of Claims 9 to 13, wherein the glass frit comprises a combination of oxides taken from the group consisting of PbO, SiO₂, B₂O₃, and Al₂O₃.

15. A printed circuit board as claimed in Claim 14, wherein the glass frit by weight essentially comprises 60-75 percent PbO, 10-25 percent SiO₂, 5-30 percent B₂O₃, and 0-10 percent Al₂O₃.

16. A printed circuit board as claimed in Claim 15, wherein by weight the glass frit is about 66.6 percent PbO, 22.4 percent SiO₂, 8.7 percent B₂O₃, and 2.3 percent Al₂O₃.

17. A printed circuit board as claimed in Claim 12, wherein by weight the composition is essentially about 10-20 percent glass frit, 10-40 percent alumina, and the remainder the screening agent.

18. A printed circuit board as claimed in Claim 17, wherein by weight the composition is essentially about 10 percent glass frit, 10 percent alumina, and the remainder the screening agent.

19. A printed circuit board as claimed in Claim 17, wherein by weight the composition is essentially about 17 percent glass frit, 33 percent alumina, and the remainder the screening agent.

20. A printed circuit board as claimed in Claim 17, wherein by weight the composition is essentially about 20 percent glass frit, 40 percent alumina, and the remainder the screening agent.

21. A printed circuit board as claimed in any one of Claims 8 to 20, wherein the inhibitor layer (1016) has a thickness in the range 0.0025 to 0.025 mm.

22. A printed circuit board as claimed in Claim 21, wherein the inhibitor layer (1016) has a thickness in the range 0.005 to 0.013 mm.

23. A printed circuit board as claimed in Claim 8, wherein the inhibitor layer (1016) is formed from a composition including a screening agent, a refractory material, and an oxide binder.

24. A printed circuit board as claimed in Claim 23, wherein the oxide binder is Bi₂O₃.

25. A printed circuit board as claimed in any one of Claims 4 to 24, wherein the firmly adherent conductors and/or the controllably adherent conductors are a metal taken from the group consisting of copper, nickel, silver, palladium, platinum and gold and/or alloys thereof.

26. A printed circuit board as claimed in any one of Claims 4 to 25, wherein the support member (40) is of alumina.

27. A printed circuit board comprising a support member (4012) having an insulative top surface (4212); a plurality of firmly adherent conductors (1014b) firmly secured to the top surface of the support member; a plurality of controllably adherent conductors (1014a) each having a first end in electrical contact with a corresponding firmly adherent conductor, an intermediate portion, and a second end for electrical connection to an electrical module (2012), the intermediate portion of each controllably adherent conductor between its first and second ends being adhered to the support member during manufacture of the printed circuit board; and an inhibitor layer (1016) on the top surface (4212) of the support member (4012), the intermediate portion and the second end of each controllably adherent conductor being positioned on the inhibitor layer; characterised in that at least the intermediate portion of the controllably adherent conductors (1014) can move and/or lift relative to the top surface (4212) of the support member (4012) when the printed circuit board is operating and exposed to stresses, the inhibit layer remaining attached to the top surface or attached to the controllably adherent conductor during moving and/or lifting of the controllably adherent conductor; and in that the inhibit layer comprises a screening agent, a refractory material and a glass frit.

28. A printed circuit board assembly comprising a printed circuit board as claimed in any one of Claims 4 to 27; and an electrical module (20) having external contacts (30) electrically connected to the second ends (60a) of the controllably adherent conductors (60).

## Patentansprüche

1. Ein Verfahren des Bildens einer Leiterplatte, das die Schritte umfaßt, daß auf einem Trägerglied (4012) eine mit Muster versehene Schicht (1016) einer ersten Zusammensetzung gedruckt und getrocknet wird; und auf dem Trägerglied eine mit Muster versehene Schicht (1014) einer zweiten Zusammensetzung einschließlich Teilen, die über Teilen der mit Muster versehenen Schicht der ersten Zusammensetzung liegen, gedruckt und getrocknet wird; gekennzeichnet dadurch, daß die zwei mit Muster versehenen Schichten zum Bilden eines ersten Musters von fest haftenden Leitern aus der mit Muster versehenen Schicht der zweiten Zusammensetzung in engem Kontakt mit dem Trägerglied und eines zweiten Musters von auf steuerbare Weise haftenden Leitern auf dem Trägerglied durch Brennen gebildet werden, wobei Teile der mit Muster versehenen Schicht der zweiten Zusammensetzung über Teilen der mit Muster versehenen Schicht der ersten Zusammensetzung liegen, wobei auf steuerbare Weise haftende Leiter an dem Trägerglied und/oder der mit Muster versehenen Schicht der ersten Zusammensetzung während des Brennens angehaftet werden, aber fähig sind, sich relativ zu dem Trägerglied während des Betriebs der Leiterplatte abzuheben.

2. Ein Verfahren nach Anspruch 1, worin die erste Zusammensetzung im wesentlichen eine Siebschicht, Glasfritte und Aluminiumoxid umfaßt; und die zweite Zusammensetzung im wesentlichen ein Siebmittel, ein metallisches Pulver und Adhäsionsbegünstiger umfaßt.

3. Ein Verfahren nach Anspruch 2, worin das metallische Pulver Kupferpulver ist.

4. Eine Leiterplatte mit einem Trägerglied (40) mit einer isolierenden oberen Fläche (42); einer Vielzahl von fest haftenden Leitern (50), die fest an der oberen Fläche des Trägergliedes angebracht sind; und einer Vielzahl von auf steuerbare Weise haftenden Leitern (60), wovon jeder ein erstes Ende (60b) in elektrischem Kontakt mit einem entsprechenden fest haftenden Leiter, ein Zwischenteil und ein zweites Ende (60a) für die elektrische Verbindung an ein elektrisches Modul (20) aufweist, wobei das Zwischenteil von jedem auf steuerbare Weise haftenden Leiter zwischen seinen ersten und zweiten Enden an dem Trägerglied während der Herstellung der Leiterplatte angehaftet ist;
dadurch gekennzeichnet,
daß zumindest der Zwischenteil der auf steuerbare Weise haftenden Leitern (60) relativ zu der oberen Fläche (42) des Trägergliedes (40) abheben kann, wenn die Leiterplatte sich in Betrieb befindet und Beanspruchungen ausgesetzt ist.

5. Eine Leiterplatte nach Anspruch 4, worin das zweite Ende (60a) von jedem auf steuerbare Weise haftenden Leiter (60) sich auch abheben kann, um Belastungen zu entlasten.

6. Eine Leiterplatte nach einem der Ansprüche 1 bis 5, worin die fest haftenden Leiter einzig in der Form von Kontaktflecken (52) vorliegen.

7. Eine Leiterplatte nach einem der Ansprüche 1 bis 6, worin jeder auf steuerbare Weise haftende Leiter und sein entsprechend fest haftender Leiter einstückig in einem Stück (1014) gebildet sind.

8. Eine Leiterplatte nach Anspruch 7 mit einer Hemmschicht (1016) auf der oberen Fläche (4212) des Trägergliedes (4012), worin der Zwischenteil und das zweite Ende von jedem auf steuerbare Weise haftenden Leiter auf der Hemmschicht positioniert ist, wobei die Hemmschicht an der oberen Fläche befestigt bleibt oder an dem auf steuerbare Weise haftenden Leiter während des Abhebens des auf steuerbare Weise haftenden Leiters befestigt bleibt.

9. Eine Leiterplatte nach Anspruch 8, worin die Hemmschicht (1016) aus einer Zusammensetzung mit einem Siebmittel, einem hitzebeständigen Material und einer Glasfritte gebildet ist.

10. Eine Leiterplatte nach Anspruch 9, worin das Gewichtsverhältnis der Glasfritte zu dem hitzebeständigen Material zwischen 0,1 und 2,0 beträgt.

11. Eine Leiterplatte nach Anspruch 9 oder 10, worin das Gewicht der Glasfritte und des hitzebeständigen Materials zwischen 5 und 85 Gewichtsprozent der Zusammensetzung beträgt.

12. Eine Leiterplatte nach einem der Ansprüche 9 bis 11, worin das hitzebeständige Material ein Oxid ist.

13. Eine Leiterplatte nach Anspruch 12, worin das hitzebeständige Material eines aus oder eine Kombination aus Al₂O₃, SiO₂, ZrO₂ und TiO₂ ist.

14. Eine Leiterplatte nach einem der Ansprüche 9 bis 13, worin die Glasfritte eine Kombination von Oxiden umfaßt, die aus der Gruppe gewählt ist, die aus PbO, SiO₂, B₂O₃ und Al₂O₃ besteht.

15. Eine Leiterplatte nach Anspruch 14, worin die Glasfritte an Gewicht im wesentlichen 60- 75 Prozent PbO, 10-25 Prozent SiO₂, 5-30 Prozent B₂O₃ und 0-10 Prozent Al₂O₃ umfaßt.

16. Eine Leiterplatte nach Anspruch 15, worin die Glasfritte an Gewicht ungefähr 66,6 Prozent PbO, 22,4 Prozent SiO₂, 8,7 Prozent B₂O₃ und 2,3 Prozent Al₂O₃ umfaßt.

17. Eine Leiterplatte nach Anspruch 12, worin die Zusammensetzung an Gewicht im wesentlichen ungefähr 10-20 Prozent Glasfritte, 10-40 Prozent Aluminiumoxid und der Rest das Siebmittel ist.

18. Eine Leiterplatte nach Anspruch 17, worin die Zusammensetzung an Gewicht im wesentlichen ungefähr 10 Prozent Glasfritte, 10 Prozent Aluminiumoxid und der Rest das Siebmittel ist.

19. Eine Leiterplatte nach Anspruch 17, worin an Gewicht die Zusammensetzung im wesentlichen ungefähr 17 Prozent Glasfritte, 33 Prozent Aluminiumoxid und der Rest das Siebmittel ist.

20. Eine Leiterplatte nach Anspruch 17, worin an Gewicht die Zusammensetzung im wesentlichen 20 Prozent Glasfritte, 40 Prozent Aluminiumoxid und der Rest das Siebmittel ist.

21. Eine Leiterplatte nach einem der Ansprüche 8 bis 20, worin die Hemmschicht (1016) eine Dicke in dem Bereich von 0,0025 bis 0,025 mm aufweist.

22. Eine Leiterplatte nach Anspruch 21, worin die Hemmschicht (1016) eine Dicke in dem Bereich von 0,005 bis 0,013 mm aufweist.

23. Eine Leiterplatte nach Anspruch 8, worin die Hemmschicht (1016) aus einer Zusammensetzung gebildet ist, die ein Siebmittel, ein hitzebeständiges Material und ein Oxidbindemittel umfaßt.

24. Eine Leiterplatte nach Anspruch 23, worin das Oxidbindemittel Bi₂O₃ ist.

25. Eine Leiterplatte nach einem der Ansprüche 4 bis 24, worin die fest haftenden Leiter und/oder die auf steuerbare Weise haftenden Leiter ein Metall sind, das aus der Gruppe ausgewählt ist, die aus Kupfer, Nickel, Silber, Palladium, Platin und Gold und/oder Legierungen davon besteht.

26. Eine Leiterplatte nach einem der Ansprüche 4 bis 25, worin das Trägerglied (40) aus Aluminiumoxid besteht.

27. Eine Leiterplatte mit einem Trägerglied (4012) mit einer isolierenden oberen Fläche (4212); einer Vielzahl von fest haftenden Leitern (1014b), die an der oberen Oberfläche des Trägergliedes fest befestigt sind; einer Vielzahl von auf steuerbare Weise haftenden Leitern (1014a), wobei jeder ein erstes Ende in elektrischem Kontakt mit einem entsprechenden fest haftenden Leiter, ein Zwischenteil und ein zweites Ende zur elektrischen Verbindung zu einem elektrischen Modul (2012) aufweist, das Zwischenteil von jedem auf steuerbare Weise haftenden Leiter zwischen seinen ersten und zweiten Enden an das Trägerglied während der Herstellung der Leiterplatte gehaftet ist; und einer Hemmschicht (1016) auf der oberen Fläche (4212) des Trägergliedes (4012), wobei das Zwischenteil und das zweite Ende von jedem auf steuerbare Weise haftenden Leiter auf der Hemmschicht positioniert sind; dadurch gekennzeichnet,
daß zumindest das Zwischenteil der auf steuerbare Weise haftenden Leiter (1014) sich relativ zu der oberen Fläche (4212) des Trägergliedes (4012) bewegen und/oder davon abheben kann, wenn die Leiterplatte in Betrieb ist und Beanspruchungen ausgesetzt ist, wobei die Hemmschicht an der oberen Fläche befestigt oder an dem auf steuerbare Weise haftenden Leiter während der Bewegung und/oder des Abhebens des auf steuerbare Weise haftenden Leiters befestigt bleibt; und dadurch, daß die Hemmschicht ein Siebmittel, ein hitzebeständiges Material und eine Glasfritte umfaßt.

28. Eine Leiterplattenanordnung mit einer Leiterplatte nach einem der Ansprüche 4 bis 27; und einem elektrischen Modul (20) mit externen Kontakten (30), die elektrisch mit den zweiten Enden (60a) der auf steuerbare Weise haftenden Leiter (60) verbunden sind.

## Revendications

1. Procédé de formage d'une carte à circuits imprimés, comportant les étapes qui consistent à imprimer et à sécher sur un élément support (4012) une couche (1016) portant un tracé suivant une première composition ; à imprimer et à sécher sur un élément support une couche (1014) portant un tracé suivant une deuxième composition comprenant des portions recouvrant des parties de la couche portant un tracé suivant la première composition ; caractérisé par la cuisson des deux couches portant un tracé pour former sur l'élément support un premier tracé constitué par des conducteurs à adhésivité ferme à partir de la couche portant un tracé suivant la deuxième composition en contact étroit avec l'élément support, et un deuxième tracé constitué par des conducteurs à adhésivité contrôlable dans lequel des portions de la couche portant un tracé suivant la deuxième composition recouvrent des parties de la couche portant un tracé suivant la première composition, les conducteurs à adhésivité contrôlable adhérant à l'élément support et/ou à la couche portant un tracé suivant la première composition au cours de la cuisson, mais étant en mesure de se soulever par rapport à l'élément support au cours du fonctionnement de la carte à circuits imprimés.

2. Procédé selon la revendication 1, dans lequel la première composition comprend essentiellement une couche formant écran, du verre fritté, et de l'alumine ; la deuxième composition comprenant essentiellement un agent formant écran, une poudre métallique et des agents d'adhésivité.

3. Procédé selon la revendication 2, dans lequel la poudre métallique est constituée par de la poudre de cuivre.

4. Carte à circuits imprimés, comprenant un élément support (40) ayant une surface supérieure isolante (42) ; une pluralité de conducteurs à adhésivité ferme (50) fixés de façon ferme sur la surface supérieure de l'élément support ; et une pluralité de conducteurs à adhésivité contrôlable (60) ayant chacun une première extrémité (60b) en contact électrique avec un conducteur correspondant à adhésivité ferme, une partie intermédiaire et une seconde extrémité (60a) destinée à être connectée électriquement à un module électrique (20), la partie intermédiaire de chaque conducteur à adhésivité contrôlable située entre les première et deuxième extrémités adhérant à l'élément support au cours de la fabrication de la carte à circuits imprimés ; caractérisée en ce qu'au moins la partie intermédiaire des conducteurs à adhésivité contrôlable (60) peut se soulever par rapport à la surface supérieure (42) de l'élément support (40) lorsque la carte à circuits imprimés est en fonctionnement ou soumise à des contraintes.

5. Carte à circuits imprimés selon la revendication 4, dans laquelle la deuxième extrémité (60a) de chaque conducteur à adhésivité contrôlable (60) peut aussi se soulever pour libérer les contraintes.

6. Carte à circuits imprimés selon l'une quelconque des revendications 1 à 5, dans laquelle les conducteurs à adhésivité ferme ont uniquement la forme de pastilles de contact (52).

7. Carte à circuits imprimés selon l'une quelconque des revendications 1 à 6, dans laquelle chaque conducteur à adhésivité contrôlable et son conducteur à adhésivité ferme correspondant sont formés en totalité en une seule pièce (1014).

8. Carte à circuits imprimés selon la revendication 7, comportant une couche d'inhibiteur (1016) sur la surface supérieure (4212) de l'élément support (4012), dans laquelle la partie intermédiaire et la deuxième extrémité de chaque conducteur à adhésivité contrôlable est positionnée sur la couche de l'inhibiteur, la couche inhibitrice demeurant attachée à la surface supérieure ou attachée au conducteur à adhésivité contrôlable au cours du soulèvement du conducteur à adhésivité contrôlable.

9. Carte à circuits imprimés selon la revendication 8, dans laquelle la couche d'inhibiteur (1016) est formée à partir d'une composition comprenant un agent formant écran, un matériau réfractaire et du verre fritté.

10. Carte à circuits imprimés selon la revendication 9, dans laquelle le rapport en poids du verre fritté et du matériau réfractaire est compris entre 0,1 et 2,0.

11. Carte à circuits imprimés selon la revendication 9 ou la revendication 10, dans laquelle le poids du verre fritté et du matériau réfractaire est compris entre 5 et 85 % du poids de la composition.

12. Carte à circuits imprimés selon l'une quelconque des revendications 9 à 11, dans laquelle le matériau réfractaire est un oxyde.

13. Carte à circuits imprimés selon la revendication 12, dans laquelle le matériau réfractaire est constitué par un des matériaux ou une combinaison des matériaux comprenant du Al₂O₃, SiO₂, ZrO₂ et TiO₂.

14. Carte à circuits imprimés selon l'une quelconque des revendications 9 à 13, dans laquelle le terre fritté comporte une combinaison d'oxydes appartenant au groupe constitué par du PbO, SiO₂, B₂O₃ et Al₂O₃.

15. Carte à circuits imprimés selon la revendication 14, dans laquelle le verre fritté comporte en poids essentiellement 60 à 75 pour cent de PbO, 10 à 25 pour cent de SiO₂, 5 à 30 pour cent de B₂O₃, et 0 à 10 pour cent de Al₂O₃.

16. Carte à circuits imprimés selon la revendication 15, dans laquelle le verre fritté comporte en poids environ 66,6 pour cent de PbO, 22,4 pour cent de SiO₂, 8,7 pour cent de B₂O₃, et 2,3 pour cent de Al₂O₃.

17. Carte à circuits imprimés selon la revendication 12, dans laquelle la composition en poids comporte essentiellement environ 10 à 20 pour cent de verre fritté, 10 à 40 pour cent d'alumine, le reste étant constitué par un agent formant écran.

18. Carte à circuits imprimés selon la revendication 17, dans laquelle la composition en poids comporte essentiellement environ 10 pour cent de verre fritté, 10 pour cent d'alumine, le reste étant constitué par un agent formant écran.

19. Carte à circuits imprimés selon la revendication 17, dans laquelle la composition en poids comporte essentiellement environ 17 pour cent de verre fritté, 33 pour cent d'alumine, le reste étant constitué par un agent formant écran.

20. Carte à circuits imprimés selon la revendication 17, dans laquelle la composition en poids comporte essentiellement environ 20 pour cent de verre fritté, 40 pour cent d'alumine, le reste étant constitué par un agent formant écran.

21. Carte à circuits imprimés selon l'une quelconque des revendications 8 à 20, dans laquelle la couche d'inhibiteur (1016) a une épaisseur comprise entre 0,0025 et 0,025 mm.

22. Carte à circuits imprimés selon la revendication 21, dans laquelle la couche d'inhibiteur (1016) a une épaisseur comprise entre 0,005 et 0,013 mm.

23. Carte à circuits imprimés selon la revendication 8, dans laquelle la couche d'inhibiteur (1016) est constituée à partir d'une composition comprenant un agent formant écran, un matériau réfractaire et un liant constitué par un oxyde.

24. Carte à circuits imprimés selon la revendication 23, dans laquelle le liant formé par un oxyde est constitué par du Bi₂O₃.

25. Carte à circuits imprimés selon l'une quelconque des revendications 4 à 24, dans laquelle les conducteurs à adhésivité ferme et/ou les conducteurs à adhésivité contrôlable sont constitués par un métal appartenant au groupe constitué par du cuivre, du nickel, de l'argent, du palladium, du platine, de l'or et/ou des alliages de ces métaux.

26. Carte à circuits imprimés selon l'une quelconque des revendications 4 à 25, dans laquelle l'élément support (40) est constitué par de l'alumine.

27. Carte à circuits imprimés, comportant un élément support (4012) ayant une surface supérieure isolante (4212) ; une pluralité de conducteurs à adhésivité ferme (1014b) fixés fermement sur la surface supérieure de l'élément support ; une pluralité de conducteurs à adhésivité contrôlable (1014a) ayant chacun une première extrémité en contact électrique avec le conducteur à adhésivité ferme correspondant, une partie intermédiaire et une deuxième extrémité servant à établir une connexion électrique avec un module électrique (2012), la partie intermédiaire de chaque conducteur à adhérence contrôlable étant située entre sa première et sa deuxième extrémités et adhérant à l'élément support au cours de la fabrication de la carte à circuits imprimés ; et une couche d'inhibiteur (1016) située sur la surface supérieure (4212) de l'élément support (4012), la partie intermédiaire de la deuxième extrémité de chaque conducteur à adhésivité contrôlable étant positionnée sur la couche d'inhibiteur ; caractérisée en ce qu'au moins la partie intermédiaire des conducteurs à adhésivité contrôlable (1014) peut se déplacer sur la surface supérieure (4212) et/ou se soulever par rapport à la surface supérieure (4212) de l'élément support (4012) lorsque la carte à circuits imprimés fonctionne et est soumise à des contraintes, la couche inhibitrice demeurant attachée à la surface supérieure ou attachée au conducteur à adhésivité contrôlable au cours du déplacement et/ou du soulèvement du conducteur à adhésivité contrôlable ; et en ce que la couche inhibitrice comporte un agent formant écran, un matériau réfractaire et du verre fritté.

28. Assemblage d'une carte à circuits imprimés, comportant une carte à circuits imprimés selon l'une quelconque des revendications 4 à 27 ; un module électrique (20) comprenant des contacts extérieurs (30) connectés électriquement aux deuxièmes extrémités (60a) des conducteurs à adhésivité contrôlable (60).
